# EUROPÄISCHE PATENTSCHRIFT

(11) **EP 2 587 905 B1**
(45) Veröffentlichungstag und Bekanntmachung des Hinweises auf die Patenterteilung: **20.03.2019**
(21) Anmeldenummer: 12187991.0
(22) Anmeldetag: 10.10.2012
(51) Int. Cl.: H05K 7/14

(54) **Universalträger zur Montage an vertikalen Trägerprofilen eines Racks sowie Anordnung mit einem derartigen Universalträger und vertikalen Trägerprofilen eines Racks**
Universal bracket for mounting on vertical loading profiles of a rack and assembly with such a universal bracket and vertical loading profiles of a rack
Support universel destiné au montage sur des profilés de support verticaux d'un rack ainsi que l'agencement comportant un tel support universel et des profilés de support verticaux d'un rack

(30) Priorität: 28.10.2011 DE 102011117222
(43) Veröffentlichungstag der Anmeldung: 01.05.2013
(73) Patentinhaber: Fujitsu Limited, Kawasaki-shi Kanagawa 211-8588 (JP)
(72) Erfinder: Hesse, Ronny, 33175 Bad Lippspringe (DE); Blume, Johannes, 33034 Brakel (DE)
(74) Vertreter: Epping - Hermann - Fischer

(56) Entgegenhaltungen:
- US-A1- 2003 111 436
- US-A1- 2004 079 712

## Beschreibung

Die Erfindung betrifft einen Universalträger zur Montage an vertikalen Trägerprofilen eines Racks sowie eine Anordnung mit einem derartigen Universalträger und vertikalen Trägerprofilen eines Racks.

Racksysteme oder Racks sind Rahmengestelle oder -aufbauten (evtl. mit Gehäusewandungen) zur Aufnahme von elektronischen Geräten, insbesondere Computersystemen, zum Beispiel Servern. Die Racks weisen in der Regel vertikale Trägerprofile auf, welche in einem vorbestimmten Abstand zueinander angeordnet sind. Zwischen die Trägerprofile können Universalträger beziehungsweise Trägerschienen montiert werden, an denen wiederum elektronische Geräte, wie zum Beispiel Server oder weitere elektronische Komponenten (Steckdosenleisten, Anschlussmodule, etc.) festgelegt werden können.

Ein Universalträger umfasst in der Regel wenigstens zwei Teile, ein Basisteil und ein Teleskopteil, welche relativ zueinander axial verschiebbar sind. Dadurch kann der Universalträger in seiner Auszuglänge in gewissen Grenzen an den Profilabstand der vertikalen Trägerprofile des Racks angepasst werden, indem das Teleskopteil relativ zum Basisteil verschoben wird.

Bekannte Lösungen von Universalträgern sehen eine gefederte Lagerung des Teleskopteils relativ zum Basisteil vor. Teleskopteil und Basisteil können entgegen einer Federkraft eines flexiblen oder elastischen Elements ineinander geschoben werden, sodass der Universalträger zwischen die vertikalen Trägerprofile des Racks eingespannt werden kann. Aufgrund der Federkraft des flexiblen Elements werden Teleskopteil und Basisteil im montierten Zustand auseinandergetrieben und drücken an die vertikalen Trägerprofile des Racks. Durch geeignete Montageelemente, z.B. Rastzapfen oder Vorsprünge, kann der Universalträger in entsprechenden Gegenrastelementen, z.B. Profilöffnungen, an den vertikalen Trägerprofilen sicher und stabil festgelegt werden. Auf diese Weise kann ein Universalträger leicht und schnell montiert werden.

Bei einem variablen Längenbereich des Universalträgers für unterschiedliche Abstände von vertikalen Trägerprofilen in Racksystemen (z.B. Abstände von 600 mm bis 800 mm) ist die Anfederung bei herkömmlichen Systemen auf die größte Auszuglänge des Universalträgers eingestellt, wobei Basisteil und Teleskopteil für geringere Auszuglängen bei geringeren Abständen der Trägerprofile ineinandergeschoben werden.

Ein Nachteil dieser Lösungen mit Anfederung durch ein flexibles oder elastisches Element besteht somit darin, dass bei Verkürzen des Universalträgers das flexible Element zum Teil stark beansprucht wird (z.B. durch Dehnen oder Stauchen). Dabei kann das flexible Element insbesondere bei großen Längenveränderungen des Universalträgers (Teleskopteil und Basisteil werden über einen längeren Weg ineinandergeschoben) Schaden nehmen. Es ist beispielsweise denkbar, dass ein flexibles Element von seiner Ruheform oder -ausdehnung über seine Elastizitätsgrenze hinaus plastisch verformt wird, sodass eine Dehnung oder Stauchung des flexiblen Elements nicht (vollständig) reversibel ist und die Kraft der Anfederung durch das flexible Element nachlässt. Dies geht schließlich zu Lasten der Montagesicherheit des Universalträgers, da unter Umständen ein ausreichender Anpressdruck oder eine sichere Verspannung des Universalträgers zwischen den vertikalen Trägerprofilen nicht mehr gewährleistet ist.

Die Druckschrift US 2003/0111436 A1 zeigt einen Universalträger zur Montage an vertikalen Trägerprofilen eines Racks. Der Universalträger umfasst zumindest ein Basisteil und ein Teleskopteil, welches relativ zum Basisteil axial verschiebbar ist, wobei das Teleskopteil und das Basisteil über ein flexibles Element verbunden sind. Das Teleskopteil und das Basisteil bilden bei Entspannung des flexiblen Elements eine vorbestimmte Auszuglänge des Universalträgers und können entgegen einer Kraft des flexiblen Elements zusammengeschoben werden. Das flexible Element kann in einer Vielzahl von axialen Positionen relativ zum Basisteil festgelegt werden, sodass durch Verändern der axialen Position des flexiblen Elements relativ zum Basisteil die Auszuglänge des Universalträgers eingestellt werden kann. Der Universalträger gemäß der Druckschrift US 2003/0111436 A1 hat den Nachteil, dass er relativ aufwendig in der Konstruktion und Handhabung ist.

Es stellt sich somit die Aufgabe, einen verbesserten Universalträger zu beschreiben, der einfacher in der Konstruktion und Handhabung ist.

Diese Aufgabe wird durch einen Universalträger zur Montage an vertikalen Trägerprofilen eines Racks gemäß Patentanspruch 1 gelöst.

Der Universalträger umfasst zumindest ein Basisteil und ein Teleskopteil. Das Teleskopteil ist relativ zum Basisteil axial verschiebbar, wobei das Teleskopteil und das Basisteil über ein flexibles Element verbunden sind, sodass das Teleskopteil und das Basisteil bei Entspannung des flexiblen Elements eine vorbestimmte Auszuglänge des Universalträgers bilden. Weiterhin können Teleskopteil und Basisteil entgegen einer Kraft des flexiblen Elements zusammengeschoben werden, wobei das flexible Element in einer Vielzahl von axialen Positionen am Basisteil festgelegt werden kann, sodass durch Verändern der axialen Positionen des flexiblen Elements am Basisteil die Auszuglänge des Universalträgers eingestellt werden kann. Das flexible Element ist ein Federelement, welches mit einem ersten Ende an einem manuell betätigbaren Rastelement und mit einem zweiten Ende am Teleskopteil festgelegt ist. Das manuell betätigbare Rastelement kann in einer Vielzahl von axialen Positionen am Basisteil verrastet werden.

Ein derartiger Universalträger ist in seiner Auszuglänge an verschiedene Abstände von vertikalen Trägerprofilen eines Racks anpassbar. Durch eine variable Festlegung des flexiblen Elements in einer Vielzahl von axialen Positionen am Basisteil (oder am Teleskopteil oder an beiden Teilen) des Universalträgers kann die Auszuglänge zwischen Teleskopteil und Basisteil, welche über das flexible Element verbunden sind, eingestellt werden, ohne dass das flexible Element beansprucht (gedehnt oder gestaucht) werden muss.

Nach Anpassen der Auszuglänge werden Teleskopteil und Basisteil zur Montage des Universalträgers an vertikalen Trägerprofilen eines Racks entgegen einer Kraft des flexiblen Elements um einen bestimmten Weg ineinandergeschoben. Der Universalträger kann zwischen die vertikalen Trägerprofile eingesetzt werden und schließlich entgegen der Kraft des flexiblen Elements an den vertikalen Trägerprofilen verspannt werden, da Teleskopteil und Basisteil wegen der Kraft des flexiblen Elements auseinandergetrieben werden.

Durch Anpassen der Position des flexiblen Elements am Basisteil (und/oder am Teleskopteil) kann die Auszuglänge des Universalträgers unabhängig von der Beanspruchung, z.B. vom Federweg, des flexiblen Elements angepasst werden. Das bedeutet, dass durch Verändern der Position des flexiblen Elements am Basisteil (und/oder am Teleskopteil) die Auszuglänge des Universalträgers, das heißt die relative Position von Teleskopteil und Basisteil zueinander, bei Entspannung des flexiblen Elements angepasst werden kann.

Ein nachfolgendes Ineinanderschieben von Teleskopteil und Basisteil zum Spannen des Universalträgers während und nach der Montage an vertikalen Trägerprofilen führt zu einer Beanspruchung des flexiblen Elements, welche für unterschiedliche Auszuglängen des Universalträgers im Wesentlichen gleich ist. Das heißt, das flexible Element wird unabhängig von der Auszuglänge des Universalträgers bei unterschiedlichen Abständen von vertikalen Trägerprofilen eines Racks nahezu unverändert beansprucht. Ein Überspannen beziehungsweise Überdehnen oder ein zu starkes Stauchen und eine daraus resultierende Überlastung oder dauerhafte (plastische) Verformung des flexiblen Elements während einer Auszuglängenanpassung des Universalträgers an einen Abstand von Trägerprofilen kann bei dieser Lösung nicht mehr auftreten.

Wie oben erläutert, ist das flexible Element ein Federelement, welches mit einem ersten Ende am manuell betätigbaren Rastelement und mit einem zweiten Ende am Teleskopteil festgelegt ist. Das Federelement kann beispielsweise als Spiralfeder einer vorbestimmten Länge im entspannten Zustand ausgeführt sein. Das Federelement kann beispielsweise bei Ineinanderschieben von Teleskopteil und Basisteil um einen bestimmten Federweg gedehnt oder gestaucht werden. Dieser Federweg des Federelements ist jedoch aufgrund der veränderlichen Position des Federelements am Basisteil (und/oder am Teleskopteil) für unterschiedliche Auszuglängen des Universalträgers unabhängig von der tatsächlichen Auszuglänge des Universalträgers.

Wie oben erläutert, kann das manuell betätigbare Rastelement in einer Vielzahl von axialen Positionen am Basisteil verrastet werden. Über das manuell betätigbare Rastelement ist eine einfache Veränderung der axialen Position des flexiblen Elements am Basisteil möglich. Ein Benutzer muss lediglich das Rastelement betätigen und axial am Basisteil verschieben, um das flexible Element in seiner Position am Basisteil zu verändern. Das Rastelement kann in einer jeweiligen vorbestimmten Position am Basisteil verrasten und stabil festgelegt werden.

Ein beschriebenes Rastelement kann in unterschiedlichen Ausführungsformen entweder am Basisteil oder am Teleskopteil oder jeweils am Basisteil und am Teleskopteil eingerichtet sein, um das flexible Element in seiner Position derart zu verändern, dass die Auszuglänge des Universalträgers eingestellt werden kann.

Ferner wird die Aufgabe durch eine Anordnung mit einem Universalträger der erläuterten Art und vertikalen Trägerprofilen eines Racks gelöst, wobei die vertikalen Trägerprofile in einem vorbestimmten Abstand zueinander angeordnet sind und der Universalträger zwischen den vertikalen Trägerprofilen angeordnet ist.

Bevorzugt ist das flexible Element in einer vorbestimmten axialen Position aus der Vielzahl von axialen Positionen am Basisteil und/oder am Teleskopteil angeordnet, sodass die Auszuglänge des Basisteils und des Teleskopteils an den Abstand der vertikalen Trägerprofile angepasst ist.

Im montierten Zustand des Universalträgers ist das flexible Element vorteilhaft gespannt, sodass das Basisteil und das Teleskopteil des Universalträgers durch die Kraft des flexiblen Elements auseinandergetrieben werden und den Universalträger zwischen den vertikalen Trägerprofilen verspannen.

Weitere vorteilhafte Ausführungsformen sind in den Unteransprüchen sowie in der nachfolgenden Figurenbeschreibung offenbart.

Die Erfindung wird anhand mehrerer Zeichnungen näher erläutert.

Es zeigen:
- Figur 1: einen Universalträger,
- Figur 2: einen detaillierten Teilausschnitt des Universalträgers gemäß Figur 1,
- Figur 3A: eine Anordnung mit einem Universalträger gemäß den Figuren 1 und 2 und vertikalen Trägerprofilen in einem ersten Abstand und
- Figur 3B: eine Anordnung mit einem Universalträger gemäß den Figuren 1 und 2 und vertikalen Trägerprofilen in einem zweiten Abstand.

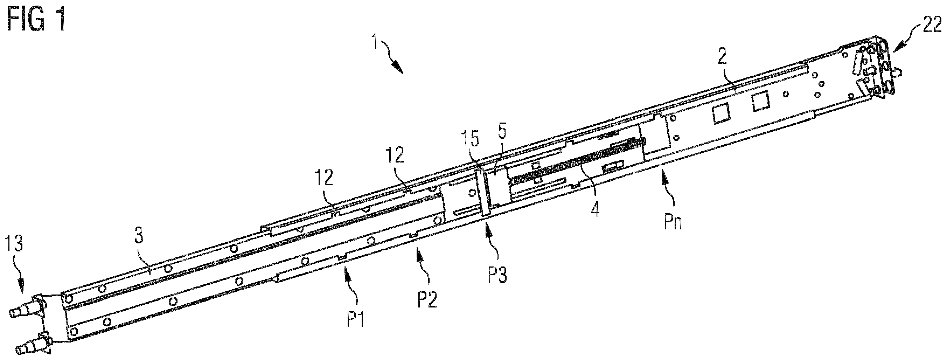

Figur 1 zeigt einen Universalträger 1 mit einem Basisteil 2 und einem Teleskopteil 3. Das Teleskopteil 3 kann relativ zum Basisteil 2 axial verschoben werden, wobei das Basisteil 2 derart geformt ist, dass es das Teleskopteil 3 zumindest teilweise klammerförmig umgreift, sodass das Teleskopteil 3 vom Basisteil 2 eingefasst ist und bei axialer Verschiebung im Basisteil 2 läuft. An den jeweiligen Stirnseiten des Basisteils 2 sowie des Teleskopteils 3 sind Montageelemente 13 beziehungsweise 22 angeordnet, welche zur Montage des Universalträgers 1 an vertikalen Trägerprofilen eines Racks dienen.

In der Regel weisen vertikale Trägerprofile Öffnungen in einem vorbestimmten Profilabstand auf, in welche ein Universalträger eingesetzt beziehungsweise eingehängt werden kann. So können die Montageelemente 13, welche in Figur 1 beispielhaft zapfenförmig ausgeführt sind, in derartige Öffnungen vertikaler Trägerprofile eingesetzt werden.

Dagegen sind die Montageelemente 22 in Figur 1 beispielhaft mit Montageöffnungen sowie einem Rastzapfen ausgeführt, wobei das Basisteil 2 über die Montageelemente 22 beispielsweise an zapfenförmigen Montagemimiken eines vertikalen Trägerprofiles angelegt und über den Rastzapfen verrastet werden kann.

Der Universalträger 1 ist beispielsweise derart eingerichtet, dass am Universalträger 1 eine Teleskopschiene für einen Auszug eines elektronischen Gerätes aus einem Rack angeordnet werden kann. Es ist auch möglich, am Universalträger 1 einen oder mehrere Auflagewinkel zur Aufnahme eines Gehäuses eines elektronischen Gerätes oder zur Aufnahme von weiteren elektronischen Komponenten, wie beispielsweise Anschlussleisten oder -komponenten einzurichten. So dient der Universalträger 1 zur universellen Halterung und Stützung elektronischer Komponenten in einem Rack.

Das Teleskopteil 3 kann, wie bereits erläutert, relativ zum Basisteil 2 axial verschoben werden. Gemäß Figur 1 sind das Basisteil 2 und das Teleskopteil 3 über ein flexibles Element 4, welches hier beispielhaft als Spiralfeder eingerichtet ist, verbunden. Ein Ende des flexiblen Elements 4 (hier das rechte Ende des flexiblen Elements 4) ist mit dem Teleskopteil 3 und ein anderes Ende des flexiblen Elements 4 (hier das linke Ende des flexiblen Elements 4) ist mit dem Basisteil 2 verbunden.

Gemäß Figur 1 ist das flexible Element 4 entspannt, wobei das Basisteil 2 und das Teleskopteil 3 eine bestimmte Auszuglänge des Universalträgers 1 bilden. Zur Montage des Universalträgers 1 an vertikalen Trägerprofilen eines Racks können das Basisteil 2 und das Teleskopteil 3 derart ineinandergeschoben werden, dass das flexible Element 4 auseinandergezogen und gedehnt wird.

Bei Ineinanderschieben des Teleskopteils 3 und des Basisteils 2 wird das rechte Ende des flexiblen Elements 4 am Teleskopteil 3 bezüglich des Basisteils 2 nach rechts verschoben. Das linke Ende des flexiblen Elements 4 am Basisteil 2 wird bezüglich des Teleskopteils 3 nach links verschoben. Dadurch wird das flexible Element 4 auseinandergezogen und gedehnt. Der auf diese Weise etwas verkürzte Universalträger 1 kann zwischen zwei vertikale Trägerprofile eines Racks eingesetzt und entgegen der Kraft des flexiblen Elements 4 schließlich an den vertikalen Trägerprofilen montiert und verspannt werden. Aufgrund der Kraft des gedehnten flexiblen Elements 4 werden das Teleskopteil 3 und das Basisteil 2 auseinandergetrieben und in montiertem Zustand gegen die vertikalen Trägerprofile des Racks gepresst, sodass der Universalträger 1 stabil an den vertikalen Trägerprofilen verrastet werden kann.

Das flexible Element 4 ist über ein Rastelement 5 mit dem Basisteil 2 verbunden. Das Rastelement 5 ist manuell betätigbar und weist in der Ausführungsform gemäß Figur 1 Rastvorsprünge 15 auf, welche in Nuten 12 am Basisteil 2 einrasten können. Die Nuten 12 sind dabei an verschiedenen Positionen P1, P2, P3 bis Pn am Basisteil 2 angeordnet.

In Figur 1 ist das Rastelement 5 beispielhaft an Position P3 arretiert. Aufgrund des Rastelements 5 kann das flexible Element 4 somit an verschiedenen Positionen des Basisteils 2 des Universalträgers 1 festgelegt werden. Das bedeutet, dass bei Verändern der Position des Rastelements 5 und bei Entspannung des flexiblen Elements 4 auch die Position des Teleskopteils 3 relativ zum Basisteil 2 und damit die Auszuglänge des Universalträgers 1 verändert werden kann.

Durch Lösen des Rastelements 5 kann beispielsweise die gesamte Anordnung des Rastelements 5, des flexiblen Elements 4 und des Teleskopteils 3 nach links verschoben werden, wobei das Teleskopteil 3 aus dem Basisteil 2 ausgezogen wird. Anschließend könnte das Rastelement 5 beispielsweise in der Position P1 wieder verrastet werden, sodass das Teleskopteil 3 und das Basisteil 2 eine größere Auszuglänge bilden als in Figur 1 über die Position P3 des Rastelements 5 dargestellt ist.

Somit kann unabhängig von der Beanspruchung des flexiblen Elements 4 die Auszuglänge des Universalträgers 1 eingestellt werden, in dem das Rastelement 5 in unterschiedlichen Positionen P1 bis Pn am Basisteil 2 festgelegt wird. Durch Verändern des Rastelements 5 in seiner Position P1 bis Pn am Basisteil 2 wird bei Ineinanderschieben des Teleskopteils 3 und des Basisteils 2 zur Montage das flexible Element 4 in unterschiedlichen Auszuglängen des Universalträgers 1 im Wesentlichen gleichmäßig gedehnt und beansprucht. Ein Verändern der Auszuglänge des Universalträgers 1 bedeutet somit keine Überbelastung und gegebenenfalls dauerhafte (plastische) Verformung des flexiblen Elements 4.

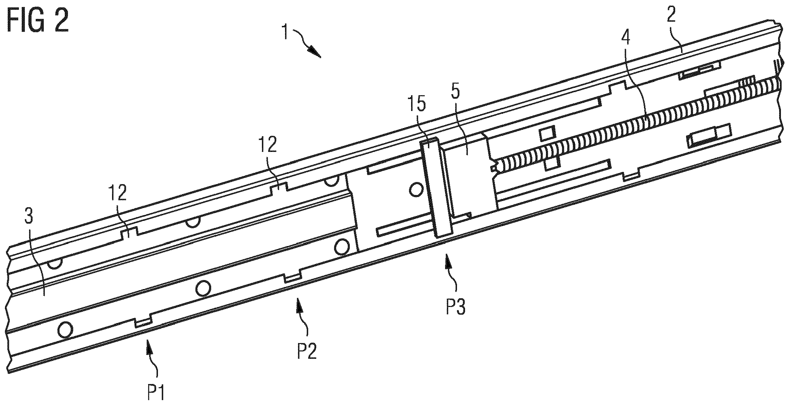

Figur 2 zeigt einen vergrößerten Ausschnitt des Universalträgers 1 gemäß Figur 1. Insbesondere ist in Figur 2 jeweils ein Teil des Basisteils 2 und des Teleskopteils 3 erkennbar, welche über das flexible Element 4 verbunden sind. Das flexible Element 4 ist mit seinem rechten Ende am Teleskopteil 3 und mit seinem linken Ende am Rastelement 5 festgelegt. Das Rastelement 5 ist wiederum am Basisteil 2 festgelegt.

Insbesondere greifen die Rastvorsprünge 15 in die Nuten 12 am Basisteil 2, sodass das Rastelement 5 in der Position P3 am Basisteil 2 festgelegt ist.

Durch Entriegeln der Rastvorsprünge 15 des Rastelements 5 am Universalträger 1 können die Rastvorsprünge 15 aus den Nuten 12 in der Position P3 gelöst werden, sodass das Rastelement 5 beispielsweise nach links verschoben und in eine der Positionen P1 oder P2 eingerastet werden kann. Auf diese Weise wird, wie bereits erläutert, das flexible Element 4 weiter links am Basisteil 2 festgelegt, sodass der Angriffspunkt des flexiblen Elements 4 am Basisteil 2 verändert wird. Dabei wird auch das Teleskopteil 3 nach links aus dem Basisteil 2 ausgezogen, wenn das flexible Element 4 weiterhin entspannt bleibt. Dadurch wird die Auszuglänge des Universalträgers 1 vergrößert. Ein Spannen des flexiblen Elements 4 wird erst bei Montage des Universalträgers 1 vollzogen und ist somit unabhängig vom Einstellen der Auszuglänge des Universalträgers 1.

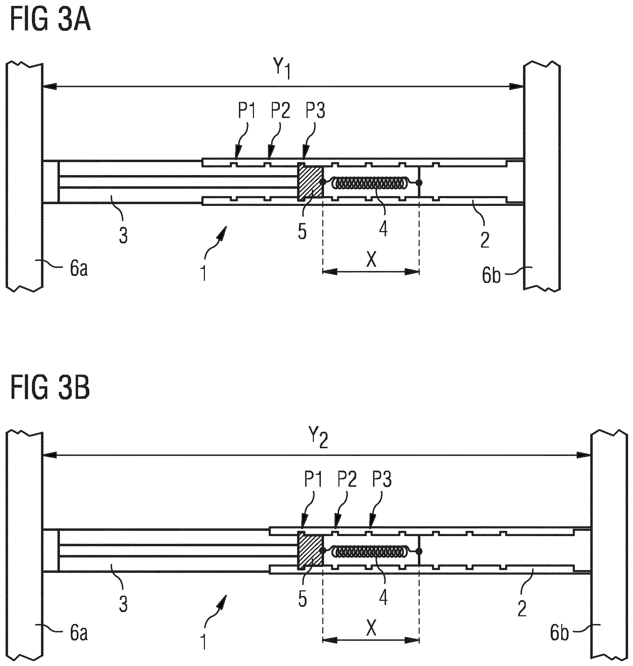

In den Figuren 3A und 3B ist schließlich die Anpassung der Auszuglänge des Universalträgers 1 an einen unterschiedlichen Abstand Y1 beziehungsweise Y2 von vertikalen Trägerprofilen 6a, 6b eines Racks verdeutlicht.

Figur 3A zeigt eine Anordnung mit vertikalen Trägerprofilen 6a, 6b eines Racks und einem Universalträger 1 der vorgenannten Art. Die vertikalen Trägerprofile 6a, 6b sind in einem ersten Abstand Y1 zueinander angeordnet. Zwischen den vertikalen Trägerprofilen 6a, 6b ist der Universalträger 1 angeordnet. Der Universalträger 1 weist das Basisteil 2 und das Teleskopteil 3 auf, welche in einer vorbestimmten Position zueinander angeordnet sind, sodass sich der Universalträger 1 im Abstand Y1 zwischen den vertikalen Trägerprofilen 6a, 6b erstreckt.

Insbesondere ist das Rastelement 5 in der Ausführung gemäß Figur 3A in der Position P3 am Basisteil 2 arretiert. Dadurch ist eine vorbestimmte Auszuglänge des Universalträgers 1 vorgegeben, welche an den Abstand Y1 angepasst ist.

Ferner weist das flexible Element 4, welches das Basisteil 2 und das Teleskopteil 3 des Universalträgers 1 kraftschlüssig verbindet, eine bestimmte Ausdehnung X auf. Vorteilhaft ist das flexible Element 4 in der Ausdehnung X derart gedehnt, dass es eine Kraft auf das Teleskopteil 3 beziehungsweise das Basisteil 2 an den jeweiligen Angriffspunkten (Verbindungspunkte mit dem Teleskopteil 3 und dem Basisteil 2) ausübt, sodass das Teleskopteil 3 und das Basisteil 2 auseinandergetrieben werden.

Auf diese Weise wird das Teleskopteil 3 nach links an das linke vertikale Trägerprofil 6a und das Basisteil 2 nach rechts an das rechte vertikale Trägerprofil 6b gedrückt. Somit ist der Universalträger 1 gemäß Figur 3A zwischen den vertikalen Trägerprofilen 6a, 6b verspannt und stabil an den vertikalen Trägerprofilen 6a, 6b im Abstand Y1 festgelegt. Eine Arretierung des Universalträgers 1 an den vertikalen Trägerprofilen 6a, 6b kann beispielsweise durch Montageelemente 13 und 22 erfolgen, wie sie zu Figur 1 erläutert wurden.

Figur 3B zeigt schließlich eine Anordnung mit vertikalen Trägerprofilen 6a, 6b und einem Universalträger 1, wobei jedoch im Unterschied zu Figur 3A die vertikalen Trägerprofile 6a, 6b in einem zweiten Abstand Y2 angeordnet sind, welcher größer ist als der Abstand Y1 gemäß Figur 3A.

Zur Anpassung des Universalträgers 1 an den zweiten Abstand Y2 ist das Rastelement 5 nicht in der Position P3 (wie in Figur 3A gezeigt), sondern in der Position P1 verrastet. Auf diese Weise ist das Teleskopteil 3 weiter aus dem Basisteil 2 herausgezogen, sodass die gesamte Auszuglänge des Universalträgers 1 an den zweiten Abstand Y2 angepasst ist. Das flexible Element 4 weist jedoch auch in Figur 3B eine Ausdehnung X auf, welche nahezu gleich ist zur Ausdehnung X gemäß Figur 3A. Somit ist das flexible Element 4 in Figur 3B trotz eines breiteren Abstands Y2 zwischen den vertikalen Trägerprofilen 6a, 6b nicht wesentlich stärker oder schwächer beansprucht als in Figur 3A, weil der Angriffspunkt des flexiblen Elements 4 am Basisteil 2 im Vergleich zur Ausführung in Figur 3A versetzt ist (P1 anstatt P3). Dennoch ist das flexible Element 4 auch in Figur 3B, wie bereits zu Figur 3A erläutert, vorteilhaft etwas gedehnt, sodass eine Spannkraft auf das Basisteil 2 und das Teleskopteil 3 zur Verspannung des Universalträgers 1 zwischen den vertikalen Trägerprofilen 6a und 6b aufgebracht ist.

In nicht dargestellten Ausführungsformen kann ein Rastelement 5 zur veränderlichen Position des flexiblen Elements 4 in Ergänzung oder alternativ zu den dargestellten Ausführungsformen auch am Teleskopteil 3 eingerichtet sein. Es wäre beispielsweise denkbar, das flexible Element 4 an einer unveränderlichen Position am Basisteil 2 festzulegen, wobei über ein Rastelement 5 eine veränderliche Positionsfestlegung des flexiblen Elements 4 am Teleskopteil 3 eingerichtet ist. Dies würde schließlich eine Funktionsumkehr des erläuterten Prinzips zwischen Basisteil 2 und Teleskopteil 3 bezogen auf die Anpassung der Auszuglänge des Universalträgers 1 darstellen.

Es ist auch denkbar, das flexible Element 4 sowohl über ein Rastelement 5 am Basisteil 2 (wie dargestellt und erläutert), als auch über ein Rastelement 5 am Teleskopteil 3 festzulegen. Auf diese Weise könnte ein Angriffspunkt des flexiblen Elements 4 sowohl am Basisteil 2 als auch am Teleskopteil 3 veränderlich sein.

### Bezugszeichenliste

- 1: Universalträger
- 2: Basisteil
- 3: Teleskopteil
- 4: flexibles Element
- 5: Rastelement
- 6a, 6b: vertikale Trägerprofile
- 12: Nuten
- 13: Montageelement
- 15: Rastvorsprünge
- 22: Montageelement
- P1 bis Pn: axiale Positionen des Rastelements
- Y1, Y2: Abstand der vertikalen Trägerprofile
- X: Ausdehnung des flexiblen Elements

## Patentansprüche

1. Universalträger (1) zur Montage an vertikalen Trägerprofilen (6a, 6b) eines Racks, wobei der Universalträger (1) zumindest ein Basisteil (2) und ein Teleskopteil (3) umfasst, welches relativ zum Basisteil (2) axial verschiebbar ist, wobei das Teleskopteil (3) und das Basisteil (2) über ein flexibles Element (4) verbunden sind, sodass das Teleskopteil (3) und das Basisteil (2) bei Entspannung des flexiblen Elements (4) eine vorbestimmte Auszuglänge des Universalträgers (1) bilden und entgegen einer Kraft des flexiblen Elements (4) zusammengeschoben werden können, und wobei das flexible Element (4) in einer Vielzahl von axialen Positionen am Basisteil (2) festgelegt werden kann, sodass durch Verändern der axialen Position des flexiblen Elements (4) am Basisteil (2) die Auszuglänge des Universalträgers (1) eingestellt werden kann, wobei das flexible Element (4) ein Federelement ist,
**dadurch gekennzeichnet, dass**
das Federelement mit einem ersten Ende an einem manuell betätigbaren Rastelement (5) und mit einem zweiten Ende am Teleskopteil (3) festgelegt ist, wobei das manuell betätigbare Rastelement (5) in einer Vielzahl von axialen Positionen (P1,...,Pn) am Basisteil (2) verrastet werden kann.

2. Universalträger (1) nach Anspruch 1, wobei das Rastelement (5) des Basisteils (2) Rastvorsprünge (15) aufweist, welche lösbar in Nuten (12) am Basisteil (2) verrastet sind.

3. Universalträger (1) nach Anspruch 1 oder 2, wobei das Basisteil (2) und das Teleskopteil (3) an ihrer jeweiligen Stirnseite Montageelemente (13, 22) aufweisen zur Montage des Universalträgers (1) an vertikalen Trägerprofilen (6a, 6b) eines Racks.

4. Anordnung mit einem Universalträger (1) nach einem der Ansprüche 1 bis 3 und vertikalen Trägerprofilen (6a, 6b) eines Racks, wobei die vertikalen Trägerprofile (6a, 6b) in einem vorbestimmten Abstand (Y1, Y2) zueinander angeordnet sind und der Universalträger (1) zwischen den vertikalen Trägerprofilen (6a, 6b) angeordnet ist.

5. Anordnung nach Anspruch 4, wobei das flexible Element (4) in einer vorbestimmten axialen Position aus der Vielzahl von axialen Positionen am Basisteil (2) angeordnet ist, sodass die Auszuglänge des Basisteils (2) und des Teleskopteils (3) an den Abstand (Y1, Y2) der vertikalen Trägerprofile (6a, 6b) angepasst ist.

6. Anordnung nach Anspruch 4 oder 5, wobei das flexible Element (4) des Universalträgers (1) gespannt ist, sodass das Basisteil (2) und das Teleskopteil (3) des Universalträgers (1) durch die Kraft des flexiblen Elements (4) auseinandergetrieben werden und den Universalträger (1) zwischen den vertikalen Trägerprofilen (6a, 6b) verspannen.

## Claims

1. Universal carrier (1) for installation on vertical support profiles (6a, 6b) of a rack, wherein the universal carrier (1) comprises at least a base part (2) and a telescoping part (3) movable axially with respect to the base part (2), wherein the telescoping part (3) and the base part (2) are connected via a flexible element (4) such that the telescoping part (3) and the base part (2) form a predetermined extension length of the universal carrier (1) when the flexible element (4) is relaxed and can be pushed together against a force of the flexible element (4), and wherein the flexible element (4) can be fixed in a plurality of axial positions on the base part (2) such that the extension length of the universal carrier (1) can be adjusted by varying the axial position of the flexible element (4) on the base part (2),
wherein the flexible element (4) is a spring element, **characterized in that**
the spring element is fixed at a first end to a manually-operable latch element (5) and at a second end to the telescoping part (3), wherein the manually-operable latch element (5) can be locked in a plurality of axial positions (P1, ..., Pn) on the base part (2).

2. Universal carrier (1) according to claim 1, wherein the latch element (5) of the base part (2) comprises catch projections (15) detachably engaged in grooves (12) on the base part (2).

3. Universal carrier (1) according to claim 1 or 2, wherein the base part (2) and the telescoping part (3) comprise mounting elements (13, 22) at their respective end faces for mounting the universal carrier (1) on vertical support profiles (6a, 6b) of a rack.

4. Arrangement comprising a universal carrier (1) according to any of claims 1 to 3, and vertical support profiles (6a, 6b) of a rack, wherein the vertical support profiles (6a, 6b) are arranged in a predetermined spacing (Y1, Y2) from one another and the universal carrier (1) is arranged between the vertical support profiles (6a, 6b).

5. Arrangement according to claim 4, wherein the flexible element (4) is arranged in a predetermined axial position from among the plurality of axial positions on the base part (2), so that the extension length of the base part (2) and of the telescoping part (3) is adapted to the spacing (Y1, Y2) of the vertical support profiles (6a, 6b).

6. Arrangement according to claim 4 or 5, wherein the flexible element (4) of the universal carrier (1) is tensioned such that the base part (2) and the telescoping part (3) of the universal carrier (1) are driven apart by the force of the flexible element (4) and brace the universal carrier (1) between the vertical support profiles (6a, 6b).

## Revendications

1. Support universel (1) servant au montage au niveau de profilés de support (6a, 6b) verticaux d'un rack, dans lequel le support universel (1) comprend au moins une partie de base (2) et une partie télescopique (3), qui peut être coulissée de manière axiale par rapport à la partie de base (2), dans lequel la partie télescopique (3) et la partie de base (2) sont reliées par l'intermédiaire d'un élément (4) flexible de sorte que la partie télescopique (3) et la partie de base (2) forment, lors du desserrage de l'élément (4) flexible, une longueur de retrait prédéfinie du support universel (1) et peuvent être assemblées à l'encontre d'une force de l'élément (4) flexible, et dans lequel l'élément (4) flexible peut être fixé dans une pluralité de positions axiales au niveau de la partie de base (2) de sorte que du fait de la modification de la position axiale de l'élément (4) flexible au niveau de la partie de base (2), la longueur de retrait du support universel (1) peut être réglée,
dans lequel l'élément (4) flexible est un élément de ressort, **caractérisé en ce que**
l'élément de ressort est fixé par une première extrémité au niveau d'un élément d'enclenchement (5) pouvant être actionné manuellement et par une seconde extrémité au niveau de la partie télescopique (3), dans lequel l'élément d'enclenchement (5) pouvant être actionné manuellement peut être enclenché dans une pluralité de positions axiales (P1, ..., Pn) au niveau de la partie de base (2).

2. Support universel (1) selon la revendication 1, dans lequel l'élément d'enclenchement (5) de la partie de base (2) présente des parties faisant saillie d'enclenchement (15), lesquelles sont enclenchées de manière amovible dans des rainures (12) au niveau de la partie de base (2).

3. Support universel (1) selon la revendication 1 ou 2, dans lequel la partie de base (2) et la partie télescopique (3) présentent, au niveau de leur côté frontal respectif, des éléments de montage (13, 22) servant au montage du support universel (1) au niveau de profilés de support (6a, 6b) verticaux d'un rack.

4. Ensemble avec un support universel (1) selon l'une quelconque des revendications 1 à 3 et des profilés de support (6a, 6b) verticaux d'un rack, dans lequel les profilés de support (6a, 6b) verticaux sont disposés à une distance (Y1, Y2) prédéterminée les uns par rapport aux autres et le support universel (1) est disposé entre les profilés de support (6a, 6b) verticaux.

5. Ensemble selon la revendication 4, dans lequel l'élément (4) flexible est disposé dans une position axiale prédéfinie issue de la pluralité de positions axiales au niveau de la partie de base (2) de sorte que la longueur de retrait de la partie de base (2) et de la partie télescopique (3) est adaptée à la distance (Y1, Y2) entre les profilés de support (6a, 6b) verticaux.

6. Ensemble selon la revendication 4 ou 5, dans lequel l'élément (4) flexible du support universel (1) est serré de sorte que la partie de base (2) et la partie télescopique (3) du support universel (1) sont écartées l'une de l'autre par la force de l'élément (4) flexible et mettent sous tension le support universel (1) entre les profilés de support (6a, 6b) verticaux.
